# EUROPEAN PATENT SPECIFICATION

(11) **EP 2 412 687 B1**
(45) Date of publication and mention of the grant of the patent: **25.04.2018**
(21) Application number: 11174932.1
(22) Date of filing: 21.07.2011
(51) Int. Cl.: C03C 19/00, B24B 37/04, C09G 1/02, C09K 3/14

(54) **Synthetic quartz glass substrate polishing slurry and manufacture of synthetic quartz glass substrate using the same**
Synthetischer Quarzglassubstrat-Polierschlamm und Herstellung von synthetischem Quarzglassubstrat damit
Suspension de polissage de substrat de verre de quartz synthétique et production de substrat de verre de quartz synthétique l'utilisant

(30) Priority: 26.07.2010 JP 2010166893
(43) Date of publication of application: 01.02.2012
(73) Proprietor: Shin-Etsu Chemical Co., Ltd., Tokyo (JP)
(72) Inventor: Matsui, Harunobu, Joetsu-shi, Niigata (JP); Harada, Daijitsu, Joetsu-shi, Niigata (JP); Takeuchi, Masaki, Joetsu-shi, Niigata (JP)
(74) Representative: Stoner, Gerard Patrick

(56) References cited:
- EP-A1- 1 580 248
- WO-A1-2009/150938
- US-A1- 2002 039 875
- US-A1- 2004 229 461

## Description

This invention relates to a polishing slurry for use in the polishing of synthetic quartz glass substrates for main use in semiconductor-related electronic materials, especially advanced electronic applications, and a method for manufacturing a synthetic quartz glass substrate using the slurry.

### BACKGROUND

Quality factors of synthetic quartz glass substrates to be considered for the purpose of reducing the feature size in pattern formation by photolithography include the size and density of defects on substrates, flatness, surface roughness, photochemical stability of material, and surface chemical stability. Of these, the quality relating to defects on substrates encounters increasingly rigorous requirements in accordance with the trends of IC technology toward finer feature size processing and magnetic media toward greater capacity.

Under the circumstances, a high-sensitivity flaw detector was developed. Research works were made for controlling surface minute defects using the flaw detector. JP-A S64-40267 discloses a method for precision polishing a glass substrate using colloidal silica. When the surface of the thus polished glass substrate is inspected for defects using the high-sensitivity flaw detector, the presence of microscopic raised or recessed defects is confirmed. The method is thus insufficient in controlling minute defects.

JP-A 2004-098278 describes a method of polishing a glass substrate using a slurry containing high-purity colloidal silica near a neutral level, thereby reducing microscopic raised defects. With the isoelectric point of colloidal silica taken into account, colloidal silica remains unstable near a neutral level. As polishing operation is repeated, the slurry experiences a viscosity buildup or a change in the particle size distribution of abrasive grains so that the slurry may not be used in a stable manner. Since this method is unamenable to recycling of the polishing slurry for repeated use, the polishing slurry is inevitably fed in one way, raising economic and environmental problems.

Our WO2009/150938 (corresponding to EP2289667 and US-A-2010/0243950) describes polishing slurries for synthetic quartz glass substrates containing a colloidal solution of colloidal silica or the like, having a colloidal concentration of 20 to 50% by weight, with pH of 9 to 10.5, and containing a component to reduce the formation of defects, selected from carboxylic acid polymers, acidic amino acids, phenols and glycosaminoglycans.

### SUMMARY

An aim of the present proposals is to provide a polishing slurry for use in the polishing of synthetic quartz glass substrates which is effective for controlling formation of defects and eventually improving the yield in the manufacture of semiconductor devices or the like, and a method for manufacturing a synthetic quartz glass substrate using the slurry.

The inventors have found that a polishing slurry comprising a collagen derivative and a colloidal solution of colloidal silica is effective for overcoming the outstanding problems.

In one aspect, as set out in claim 1, the invention provides a polishing slurry for synthetic quartz glass substrates comprising a collagen derivative which is gelatin or collagen peptide and a colloidal solution which is a colloidal silica dispersion having a colloidal silica concentration of 20 to 50% by weight, the slurry having pH of 8 to 11 and the amount of collagen derivative being 0.001 to 5% by weight based on the solids of the colloidal silica. In a preferred embodiment, the collagen derivative has glycine and hydroxyproline in its structure.

The polishing slurry may further comprise a carboxylic acid or salt thereof.

The pH of the slurry is preferably adjusted using at least one member selected from among alkali metal hydroxides, alkaline earth metal hydroxides, basic salts, amines and ammonia.

In another aspect, as in claim 11, the invention provides a method for manufacturing a synthetic quartz glass substrate through rough polishing and final polishing steps, wherein the final polishing step uses the polishing slurry defined above.

In a preferred embodiment, the polishing slurry is kept at a lower temperature than the denaturing temperature of collagen and fed to the final polishing step where polishing is carried out at a higher temperature than the denaturing temperature of collagen due to the polishing heat.

In the polishing of synthetic quartz glass, typically synthetic quartz glass substrates for use in the manufacture of photomasks, nanoimprint templates, and magnetic disks by photolithography, the polishing slurry of the invention is effective for controlling formation of defects having a size that can be detected by a high sensitivity flaw detector (e.g. 50nm or greater), on the substrate surface. The invention improves the manufacture yield of synthetic quartz glass substrates and contributes to further miniaturization in the semiconductor industry.

### FURTHER EXPLANATIONS; OPTIONS AND PREFERENCES

The polishing slurry for synthetic quartz glass substrates comprises a collagen derivative and colloidal solution.

In the course of research works, the inventors set up the following hypothesis regarding the defect forming mechanism. During polishing, abrasive grains in the polishing slurry fuse together at their surfaces or fuse to glass chips removed from the surface of glass as workpiece, forming larger grains. The polishing action causes such fused grains to be fused or attached to the glass surface, forming flaws on the surface. It is then important to mitigate the contact between the fused grains as foreign matter and the glass as workpiece.

In JP-A 2004-098278 cited above, a glass substrate is polished using a polishing slurry containing high-purity colloidal silica in the neutral region. Since the zeta-potential on grain surface is low as compared with alkaline colloidal silica which is present at about pH 10 in the stable region of colloidal silica, the electrostatic repulsive force between grains is weak, probably restraining chemical reaction-like attachment of grains to the glass surface. However, the slurry was found to prematurely gel and thicken during polishing because abrasive grains fuse together under the mechanical action of polishing. Such slurry cannot be used in actual polishing. Also grains fuse together into larger grains which may behave as foreign matter in the slurry and cause defect formation. Even when the polishing pressure is reduced so as to minimize polishing instability, the particle size distribution is shifted to a larger side under the work of the polishing plate, which may cause flaws on the substrate surface.

The inventors have found that when a collagen derivative is added to the polishing slurry, the collagen derivative forms a high molecular weight sol-gel network that can capture those colloidal silica grains which have fused together into larger grains behaving as foreign matter (although most grains remain stable under alkaline conditions), mitigating the contact of larger grains with the substrate; and that this prevents the glass surface from flawing which can otherwise occur when colloidal silica is fused or attached to the surface of glass being polished or when colloidal grains which have fused together into larger grains behaving as foreign matter impinge against the glass surface.

The collagen derivative used herein is gelatin or collagen peptide. These substances are polymers resulting from polymerization of monomers in the form of tripeptide represented by the sequence [Gly-Xaa-Yaa]ₙ wherein Xaa and Yaa are amino acids and n is a degree of polymerization.

Preferably the collagen derivative has a weight average molecular weight (Mw) of 1,000 to 10,000,000, more preferably 1,000 to 1,000,000. A collagen derivative with too high Mw may be undesirable for the polishing slurry since it may exhibit a greater van der Waals force between molecules, thicken, and even solidify. A collagen derivative with too low Mw may form a weak network between molecules, be unlikely to form a hydrogel, and even if it forms a network, the network is so brittle that it may fail to fully prevent larger grains of colloidal silica as foreign matter from contacting with the glass substrate as workpiece, eventually allowing flaw formation. It is noted that the weight average molecular weight is as measured by gel permeation chromatography (GPC) versus polystyrene standards.

The invention uses a collagen derivative which forms a hydrogel by utilizing its intermolecular network. The hydrogel network thus constructed serves to mitigate the contact between larger grains as foreign matter and glass as workpiece. Among amino acids included in the collagen derivative of the sequence [Gly-Xaa-Yaa]ₙ, Gly is glycine. A collagen derivative of the sequence wherein at least one of Xaa and Yaa is hydroxyproline is preferred because it is more likely to form a triple helical structure within the molecule and more susceptible to a change of state between gel and solution. A collagen derivative wherein Yaa is hydroxyproline is more preferred because the triple helical structure is more likely to stabilize and the formation and collapse of triple helical structure or a change of state between gel and solution can be controlled in terms of temperature.

Gelatin and collagen peptide have a denaturing temperature of the order of 15°C to 20°C. The polishing slurry is prepared in solution state by cooling with a cooling medium. When the slurry is used in polishing, a hydrogel is formed at the polishing plate temperature of the polishing tool which is increased by the heat generated during polishing. Accordingly, the degree of formation of hydrogel can be selected as appropriate by controlling the temperature of the polishing slurry. The temperature of the polishing slurry is controlled so as to provide optimum polishing conditions, depending on the composition and concentration of colloid in the polishing slurry.

While it is important to prevent the contact between foreign matter in the polishing slurry and glass as workpiece by forming a network of the collagen derivative, it is more preferred that the network capture water molecules in the polishing slurry to increase the moisture retention on the substrate surface, because colloidal particles as abrasive grains can then be more readily removed when the substrate is cleaned at the end of polishing. A typical humectant substance is collagen peptide.

The appropriate concentration of the collagen derivative is 0.001 to 5% by weight, preferably 0.01 to 3% by weight based on the solids of the colloidal silica. Outside the range, a lower concentration may be less effective for preventing flaws whereas a higher concentration may interfere with a stable supply of the polishing slurry to the polishing tool due to the high viscosity of the collagen derivative.

The colloidal solution contains colloidal particles of a reduced particle size as a main component, specifically a primary particle size of preferably 5 to 500 nm, more preferably 10 to 200 nm, and most preferably 20 to 150 nm. Colloidal particles with too small a particle size are effective for the polishing purpose, but tend to attach or adhere to the substrate surface, interfering with the subsequent cleaning. Colloidal particles with too large a particle size may provide a substrate as polished with a poor surface roughness and be often inconvenient to use as the abrasive for final precision polishing. It is noted that the particle size is a measurement by the dynamic light scattering (DLS) method.

The colloidal dispersion contains colloidal particles in a concentration of 20 to 50% by weight, and preferably 40 to 50% by weight. With a colloid concentration of less than 20% by weight, microscopic flaws may be formed on the glass surface by the polishing pad because the absolute amount of colloidal particles as abrasive grains in the polishing slurry is rather short, allowing direct contact of the polishing pad with the substrate. A colloid concentration of more than 50% by weight, indicating inclusion of too much colloidal particles in the slurry, leads to a likelihood of colloidal particles aggregation behavior together and the slurry may become unstable, introducing flaws in the substrate. Also too high a colloid concentration may increase the viscosity of the slurry to inhibit polishing.

For the colloidal particles, the particle size distribution may be either monodisperse or polydisperse, or multimodal. The colloidal particles include colloidal silica, colloidal silica containing the same components as the synthetic quartz glass.

Colloidal silica may be prepared by various methods, for example, granulation from water glass and hydrolysis of organic silicate compounds such as alkoxysilanes. Many dispersing media generally have alkaline pH from the standpoint of storage stability although neutral or acidic pH may be acceptable. It is preferred that the dispersing medium have pH in the range of 3 to 5 or in the range of 8 to 11 when the isoelectric point of colloidal silica is taken into account. More preferred are pH values in the range of 9 to 10.5. At near neutral pH, there is a tendency that colloidal silica particles are less electrically charged and the polishing slurry is unstable. At strong alkalinity, surface roughening may occur on the polished glass.

On use, colloidal silica is generally dispersed in water. Silica may also be dispersed in an organic solvent. Suitable organic solvents include alcohols such as ethanol and isopropyl alcohol, ketones such as acetone and methyl ethyl ketone, and aromatic compounds such as benzene, toluene, and xylene. A mixture of such organic solvents is also acceptable. Moreover, of these organic solvents and mixtures thereof, water-soluble ones may be mixed with water in any desired proportion.

As the colloidal silica dispersion liquid, commercially available products may be used, for example, COMPOL-50, COMPOL-80, COMPOL-120 and COMPOL-EXIII from Fujimi Inc., ST-XL, ST-YL, and ST-ZL from Nissan Chemical Industries, Ltd., SYTON from Dupont, and GP series from Fuso Chemical Co., Ltd.

When a synthetic quartz glass substrate is polished using the polishing slurry, the addition of collagen derivative to the polishing slurry ensures to minimize the number of defects which can be detected by a high-sensitivity flaw detector.

If necessary, additives such as pH modifiers may be added to the polishing slurry. In particular, pH adjustment of the polishing slurry is important in controlling microscopic defects. It is thus desirable to add a pH modifier in order to keep the slurry in the specified range of pH 8 to 11, more preferably pH 9 to 10.5.

Suitable pH modifiers which can be used herein include alkali metal hydroxides, alkaline earth metal hydroxides, basic salts, amines, and ammonia. Examples include potassium hydroxide, sodium hydroxide, calcium hydroxide, sodium borate, triethylamine, triethanolamine, diethanolamine, and ethylenediamine. These modifiers may be used alone or in combination of two or more. Preference is given to triethylamine capable of stabilizing the amine moiety in collagen peptide and to diethanolamine and triethanolamine capable of forming chelate complexes with metal impurities such as aluminum ions for removal.

The pH modifier is added to the polishing; slurry in such an amount as to provide pH in the range of 8 to 11. Since it is important that the pH of the polishing slurry does not deviate from this range during polishing, the sequence of adding other additives in advance and adding the pH modifier later is preferred. If the pH of the polishing slurry varies during polishing, the pH modifier may be added at an appropriate point of time so as to provide a pH value in the range. In the case of strong bases having a high dissociation constant like sodium hydroxide, pH adjustment is difficult because in the relevant pH range, even a small difference in addition amount may result in a substantial variation of pH. In this regard, amines which are bases of moderate strength, such as diethanolamine, triethanolamine and triethylamine are the preferred pH modifiers. At near neutral pH, colloidal silica tends to be unstable which is inconvenient for continuous polishing. At too high pH, surface roughening may occur on the polished quartz glass.

Additives other than the pH modifier which can be used herein include carboxylic acids and salts thereof. Specifically, carboxylic acids of chain structure and aromatic carboxylic acids may be used. Examples include malonic acid, succinic acid, maleic acid, fumaric acid, tartaric acid, malic acid, adipic acid, citric acid, benzoic acid, methylbenzoic acid, t-butylbenzoic acid, salicylic acid, phthalic acid, isophthalic acid, terephthalic acid, phenylacetic acid, and salts thereof. The additives exemplified above may be used alone or in combination of two or more. Since these molecules are bulky in aqueous solution and become an external factor to provide a steric hindrance to interaction of colloidal particles, they advantageously stabilize the polishing slurry by restraining fusion of colloidal particles.

The synthetic quartz glass substrate resulting from the inventive method may be used in the fields of semiconductor-related electronic materials, and especially in photomask, nanoimprint and magnetic disk applications.

According to the method of the invention, a synthetic quartz glass substrate is manufactured through rough polishing and final finish precision polishing steps. Specifically a synthetic quartz glass substrate is prepared from a synthetic quartz glass ingot by shaping, annealing, slicing, chamfering, lapping, and rough polishing to mirror finish. The rough polishing is followed by precision polishing by which the final surface quality of a synthetic quartz glass substrate is decided. The final polishing step uses the polishing slurry defined herein.

At this point, the polishing slurry is kept at a temperature below the denaturing temperature of collagen by cooling with a suitable coolant. During polishing of the glass substrate, the temperature of the polishing slurry is increased beyond the denaturing temperature by the polishing heat. Then a hydrogel forms during polishing. At the end of polishing, the polishing slurry is recovered and cooled again whereupon it is ready for reuse. Since the gel is broken at this point, the polishing slurry becomes more flowable so that it may be smoothly pumped to the polishing tool.

It is noted that the polishing mode using the polishing slurry defined herein is typically batchwise double-side polishing although single-side polishing, single-substrate polishing or a combination thereof may also be acceptable.

### EXAMPLE

Examples and Comparative Examples are given below for illustrating the invention, but the invention is not limited thereto.

### Example 1

A synthetic quartz glass substrate stock as sliced (152.4mm/6 inches) was lapped and roughly polished, after which it was subjected to final finish precision polishing. A soft suede-type polishing pad was used. A polishing slurry was prepared by adding 1.0% by weight of collagen peptide (average molecular weight 2,000, Wako Pure Chemical Industries Ltd.) to a colloidal silica water dispersion having a SiO₂ concentration of 40% by weight (Fujimi Inc., primary particle size 77.3 nm) and adjusted to pH 10.2 by adding diethanolamine and triethylamine. It was found by circular dichroism (CD) analysis that the collagen peptide added herein formed a triple helical structure at a temperature of 10°C in the reservoir prior to pumping and the triple helical structure collapsed at a polishing temperature of 25°C which was measured as the polishing plate temperature of the polishing tool. Polishing was done under a pressure of 100gf/cm². The polishing allowance was an amount sufficient to remove the flaws introduced in the rough-polishing step (equal to or more than 2 µm).

At the end of polishing, the substrate was cleaned and dried. Defect inspection was carried out using a laser confocal optical system high-sensitivity flaw detector (Lasertec Corp.). The number of defects having a size of 50 nm or greater was 1.3 on average.

### Comparative Example 1

The procedure of Example 1 was repeated under the same conditions except that no collagen peptide was added to the polishing slurry used in the final polishing. Upon similar defect inspection, the number of defects having a size of 50 nm or greater was 57 on average.;

### Example 2

The procedure of Example 1 was repeated under the same conditions except that 1.0% by weight of gelatin originating from salmon (average molecular weight 300,000, Ihara & Co., Ltd.) was used instead of the collagen peptide. Upon similar defect inspection, the number of defects having a size of 50 nm or greater was 1.8 on average.

### Example 3

The procedure of Example 1 was repeated under the same conditions except that 0.8% by weight of gelatin originating from salmon (average molecular weight 300,000, Ihara & Co., Ltd.) and 0.2% by weight of sodium benzoate were used instead of the collagen peptide. Upon similar defect inspection, the number of defects having a size of 50 nm or greater was 2.5 on average,

### Example 4

A synthetic quartz glass substrate stock as sliced (152.4mm/6 inches) was lapped and roughly polished, after which it was subjected to final finish precision polishing. A soft suede-type polishing pad was used. A polishing slurry was prepared by adding 0.5% by weight of collagen peptide to a colloidal silica water dispersion having a SiO₂ concentration of 40% by weight (Fuso Chemical Co., Ltd., primary particle size 105 nm) and adjusted to pH 9.7 by adding diethanolamine. Polishing was done under a pressure of 100 gf/cm². The polishing allowance was an amount sufficient to remove the flaws introduced in the rough-polishing step (equal to or more than 2 µm). Upon defect inspection as in Example 1, the number of defects having a size of 50 nm or greater was 2.8 on average.

### Example 5

The procedure of Example 4 was repeated under the same conditions except that 0.1% by weight of gelatin originating from salmon in Example 2 was used instead of the collagen peptide and the slurry was adjusted to pH 10.2 by adding diethanolamine. Upon similar defect inspection, the number of defects having a size of 50 nm or greater was 2.1 on average.

In respect of numerical ranges disclosed in the present description it will of course be understood that in the normal way the technical criterion for the upper limit is different from the technical criterion for the lower limit, i.e. the upper and lower limits are intrinsically distinct proposals.

## Claims

1. A polishing slurry for synthetic quartz glass substrates, comprising a collagen derivative which is gelatin or collagen peptide and a colloidal solution which is a colloidal silica dispersion having a colloidal silica concentration of 20 to 50% by weight, the slurry having pH 8 to 11 and the amount of collagen derivative being 0.001 to 5% by weight based on the solids of the colloidal silica.

2. A polishing slurry of claim 1 in which the amount of collagen derivative is 0.01 to 3% by weight based on the solids of the colloidal silica.

3. A polishing slurry of claim 1 or 2 in which the collagen derivative has a weight average molecular weight of from 1,000 to 1,000,000, as measured by gel permeation chromatography against polystyrene standards.

4. A polishing slurry of any one of the preceding claims in which the colloidal particles in the colloidal solution have a primary particle size of 5 to 500 nm, as measured by the dynamic light scattering method.

5. A polishing slurry of any one of the preceding claims in which the colloidal dispersion contains colloidal particles in a concentration of 40 to 50% by weight.

6. A polishing slurry of any one of the preceding claims, further comprising a carboxylic acid or salt thereof.

7. A polishing slurry of claim 6 in which the carboxylic acid or salt thereof is selected from malonic acid, succinic acid, maleic acid, fumaric acid, tartaric acid, malic acid, adipic acid, citric acid, benzoic acid, methylbenzoic acid, t-butylbenzoic acid, salicylic acid, phthalic acid, isophthalic acid, terephthalic acid, phenylacetic acid, and salts thereof.

8. A polishing slurry of any one of the preceding claims having pH of 9 to 10.5.

9. A polishing slurry of any one of the preceding claims to which at least one of alkali metal hydroxides, alkaline earth metal hydroxides, basic salts, amines and ammonia has been added as pH modifier.

10. A polishing slurry of claim 9 to which triethylamine, triethanolamine or diethanolamine has been added as pH modifier.

11. A method for manufacturing a synthetic quartz glass substrate through rough polishing and final polishing steps, wherein the final polishing step uses a polishing slurry of any one of claims 1 to 10.

12. A method of claim 11 wherein said polishing slurry is kept at a lower temperature than the denaturing temperature of collagen and fed to the final polishing step where polishing is carried out at a higher temperature than the denaturing temperature of collagen due to the polishing heat.

13. A method of claim 11 or 12 wherein during polishing pH modifier is added to the polishing slurry to keep the pH in the range 8 to 11.

## Patentansprüche

1. Polierschlamm für synthetische Quarzglassubstrate, der ein Collagenderivat, das Gelatine oder Collagenpeptid ist, sowie eine kolloidale Lösung, die eine kolloidale Siliciumdioxid-Dispersion mit einer kolloidalen Siliciumdioxidkonzentration von 20 bis 50 Gew.-% ist, umfasst, wobei der Schlamm einen pH-Wert von 8 bis 11 aufweist und die Menge an Collagenderivat 0,001 bis 5 Gew.-% bezogen auf die Feststoffe des kolloidalen Siliciumdioxids beträgt.

2. Polierschlamm nach Anspruch 1, bei dem die Menge an Collagenderivat 0,01 bis 3 Gew.-% bezogen auf die Feststoffe des kolloidalen Siliciumdioxids ist.

3. Polierschlamm nach Anspruch 1 oder 2, bei dem das Collagenderivat ein gewichtsmittleres Molekulargewicht von 1.000 bis 1.000.000 aufweist, gemessen mittels Gelpermeationschromatografie im Vergleich zu Polystyrol-Standards.

4. Polierschlamm nach einem der vorangegangenen Ansprüche, bei dem die kolloidalen Partikel in der kolloidalen Lösung eine Primärpartikelgröße von 5 bis 500 nm aufweisen, gemessen mit dem Verfahren der dynamischen Lichtstreuung.

5. Polierschlamm nach einem der vorangegangenen Ansprüche, bei dem die kolloidale Dispersion kolloidale Partikel in einer Konzentration von 40 bis 50 Gew.-% enthält.

6. Polierschlamm nach einem der vorangegangenen Ansprüche, der des Weiteren eine Carbonsäure oder ein Salz davon umfasst.

7. Polierschlamm nach Anspruch 6, bei dem die Carbonsäure oder das Salz davon aus Malonsäure, Bernsteinsäure, Maleinsäure, Fumarsäure, Weinsäure, Apfelsäure, Adipinsäure, Citronensäure, Benzoesäure, Methylbenzoesäure, t-Butylbenzoesäure, Salicylsäure, Phthalsäure, Isophthalsäure, Terephthalsäure, Phenylessigsäure und Salzen davon ausgewählt ist.

8. Polierschlamm nach einem der vorangegangenen Ansprüche, der einen pH-Wert von 9 bis 10,5 aufweist.

9. Polierschlamm nach einem der vorangegangenen Ansprüche, zu dem zumindest eines aus Alkalimetallhydroxiden, Erdalkalimetallhydroxiden, basischen Salzen, Aminen und Ammoniak als pH-Modifikator hinzugefügt wurde.

10. Polierschlamm nach Anspruch 9, zu dem Triethylamin, Triethanolamin oder Diethanolamin als pH-Modifikator hinzugefügt wurde.

11. Verfahren zur Herstellung eines synthetischen Quarzglassubstrats mittels Grobpolier- und Hochglanzpolierschritten, worin der Hochglanzpolierschritt einen Polierschlamm nach einem der Ansprüche 1 bis 10 verwendet.

12. Verfahren nach Anspruch 11, worin der Polierschlamm auf einer niedrigeren Temperatur gehalten wird als der Denaturierungstemperatur von Collagen und in den Hochglanzpolierschritt eingespeist wird, wobei das Polieren aufgrund der Polierwärme bei einer höheren Temperatur als der Denaturierungstemperatur von Collagen durchgeführt wird.

13. Verfahren nach Anspruch 11 oder 12, worin während des Polierens ein pH-Modifikator zum Polierschlamm hinzugefügt wird, um den pH-Wert im Bereich von 8 bis 11 zu halten.

## Revendications

1. Suspension de polissage pour substrats de verre de quartz synthétique, comprenant un dérivé de collagène qui est de la gélatine ou un peptide de collagène et une solution colloïdale qui est une dispersion de silice colloïdale ayant une concentration de silice colloïdale de 20 à 50 % en poids, la suspension ayant un pH de 8 à 11 et la quantité de dérivé de collagène étant de 0,001 à 5 % en poids sur la base des matières solides de la silice colloïdale.

2. Suspension de polissage selon la revendication 1 dans laquelle la quantité de dérivé de collagène est de 0,01 à 3 % en poids sur la base des matières solides de la silice colloïdale.

3. Suspension de polissage selon la revendication 1 ou 2 dans laquelle le dérivé de collagène a un poids moléculaire moyen en poids de 1 000 à 1 000 000, tel que mesuré par chromatographie d'exclusion diffusion par rapport à des étalons de polystyrène.

4. Suspension de polissage selon l'une quelconque des revendications précédentes dans laquelle les particules colloïdales dans la solution colloïdale ont une taille de particule primaire de 5 à 500 nm, telle que mesurée par le procédé de diffusion dynamique de la lumière.

5. Suspension de polissage selon l'une quelconque des revendications précédentes dans laquelle la dispersion colloïdale contient des particules colloïdales dans une concentration de 40 à 50 % en poids.

6. Suspension de polissage selon l'une quelconque des revendications précédentes, comprenant en outre un acide carboxylique ou un sel de celui-ci.

7. Suspension de polissage selon la revendication 6 dans laquelle l'acide carboxylique ou le sel de celui-ci est choisi parmi l'acide malonique, l'acide succinique, l'acide maléique, l'acide fumarique, l'acide tartrique, l'acide malique, l'acide adipique, l'acide citrique, l'acide benzoïque, l'acide méthylbenzoïque, l'acide t-butylbenzoïque, l'acide salicylique, l'acide phtalique, l'acide isophtalique, l'acide téréphtalique, l'acide phénylacétique, et les sels de ceux-ci.

8. Suspension de polissage selon l'une quelconque des revendications précédentes ayant un pH de 9 à 10,5.

9. Suspension de polissage selon l'une quelconque des revendications précédentes à laquelle au moins l'un d'hydroxydes de métaux alcalins, d'hydroxydes de métaux alcalino-terreux, de sels basiques, d'amines et d'ammoniaque a été ajouté en tant que modificateur de pH.

10. Suspension de polissage selon la revendication 9 à laquelle de la triéthylamine, de la triéthanolamine ou de la diéthanolamine a été ajoutée en tant que modificateur de pH.

11. Procédé de fabrication d'un substrat de verre de quartz synthétique par des étapes de polissage grossier et de polissage final, dans lequel l'étape de polissage final utilise une suspension de polissage selon l'une quelconque des revendications 1 à 10.

12. Procédé selon la revendication 11 dans lequel ladite suspension de polissage est maintenue à une température inférieure à la température de dénaturation du collagène et introduite dans l'étape de polissage final où le polissage est réalisé à une température supérieure à la température de dénaturation du collagène en raison de la chaleur de polissage.

13. Procédé selon la revendication 11 ou 12 dans lequel durant le polissage un modificateur de pH est ajouté à la suspension de polissage pour maintenir le pH dans la plage de 8 à 11.
